Europäisches Patentamt

European Patent Office

Office européen des brevets

(11) Publication number: **0 096 062**
**B1**

(12) **EUROPEAN PATENT SPECIFICATION**

(45) Date of publication of patent specification: **04.06.86**

(21) Application number: **83900315.9**

(22) Date of filing: **10.12.82**

(86) International application number:
**PCT/US82/01731**

(87) International publication number:
**WO 83/02199 23.06.83 Gazette 83/15**

(51) Int. Cl.⁴: **H 01 L 29/62,** H 01 L 21/28,
H 01 L 21/314

(54) **NON-VOLATILE SEMICONDUCTOR MEMORY DEVICE AND MANUFACTURING METHOD THEREFOR.**

(30) Priority: **14.12.81 US 330345**

(43) Date of publication of application:
**21.12.83 Bulletin 83/51**

(45) Publication of the grant of the patent:
**04.06.86 Bulletin 86/23**

(84) Designated Contracting States:
**DE GB NL**

(56) References cited:
**EP-A-0 006 706**
**US-A-4 151 537**

**IEEE Transactions on electron devices, vol. ED-24, no. 5, May 1977, New York, (US), J.S. Johannessen et al.: "Auger depth profiling of MNOS structures by ion sputtering", pages 547-551**

**IEEE Transactions on electron devices, vol. ED-24, no. 5, May 1977, New York, (US), P.C.Y. Chen.: "Threshold-alterable Si-Gate MOS devices", pages 584-586**

㊻ Proprietòr: **NCR Corporation**
**World Headquarters**
**Dayton, Ohio 45479 (US)**

(72) Inventor: **YEN, Yung-Chau**
**421 Greenport Drive**
**West Carrollton OH 45449 (US)**

(74) Representative: **Robinson, Robert George**
**International Patent Department NCR Limited**
**206 Marylebone Road**
**London NW1 6LY (GB)**

(56) References cited:
**Extended abstracts of the journal of the electro-chemical society, vol. 80-2, October 1980, Princeton (US), K. Takasaki et al.: "Properties of plasma-deposited silicon oxynitride films", pages 767-769**

Courier Press, Leamington Spa, England.

## Description

Technical field

This invention relates to non-volatile semiconductor memory devices of the kind including a semiconductor substrate, a silicon oxide layer provided on said semiconductor substrate, a silicon oxynitride layer provided on said silicon oxide layer, a silicon nitride layer provided on said oxynitride layer, and a silicon gate electrode overlying said silicon nitride layer.

The invention also relates to a process for forming a non-volatile semiconductor memory device.

Background art

A non-volatile memory device is a device that can retain stored information in the absence of power. One way of accomplishing this is by using a field-effect transistor where the threshold voltage is determined by charges trapped in that gate insulator of the device. Such charge trapping may be accomplished, for example, by using a dual dielectric layer for the gate insulator, such as silicon dioxide and silicon nitride in MNOS and SNOS devices. When a suitable voltage is applied to the terminals of an MNOS transistor, charges from the transistor channel region tunnel through the normally very thin oxide layer and are trapped at the interface between the oxide and the nitride and in the nitride bulk. The nitride is made thick enough to prevent any further tunneling of charges through it. Most of the charges will remain in their trapped location since they need the influence of an electric field of opposite polarity to the one that caused them to tunnel through the thin oxide initially. This phenomenon provides the non-volatile character of the structure.

Among the most important characteristics of thin memory oxide-nitride non-volatile semiconductor memory devices is long-term charge retention, that is, the ability of the memory device to retain its stored charge subsequent to a write or clear operation.

Improving charge retention in MNOS memory devices is always a goal in microelectronics technology. One way of improving charge retention in these devices is to make the first dielectric (oxide) layer relatively thick. However, a thick memory oxide necessitates rather high voltages to write or erase the device and also decreases the device erasure speed. To decrease the write/erase voltage in the thick memory oxide devices, generally, a thin nitride layer is used. However, when a thin nitride layer is used the retention characteristic suffers. In addition, unnecessary information is written during the read mode by hot charge carriers which are generated in small amounts during the read mode, causing incorrect operation of the device.

A further desirable feature of non-volatile memory devices is a low operating voltage, thereby reducing power consumption.

A non-volatile semiconductor memory device of the kind specified is known from U.S. Patent Specification No. 4,151,537.

Disclosure of the invention

It is an object of the present invention to provide a non-volatile semiconductor memory device of the kind specified capable of providing a high degree of retention.

Therefore, according to the present invention, there is provided a non-volatile semiconductor memory device as specified in claim 1.

According to a further feature of the invention, the layer of graded silicon oxynitride is provided as a further layer of silicon oxynitride lying between the silicon nitride layer and the silicon gate electrode.

According to another aspect of the invention, there is provided a process as specified in claim 7.

A process according to the invention has the advantages of low fabrication cost, a relatively high yield and large throughput.

For ease of reference, the following definitions which are applicable herein, are set forth at this point:

"Silicon" includes polycrystalline silicon (polysilicon) and monocrystalline silicon.

"SNOS" is silicon-nitride-memory oxide-semiconductor.

"SNOOS" is silicon-nitride-ungraded oxynitride I-memory oxide-semiconductor.

"SNO$_g$OS" is silicon-nitride-graded oxynitride I-memory oxide-semiconductor.

'SONOOS" is silicon-ungraded oxynitride II-nitride-ungraded oxynitride I-oxide-semiconductor.

"SONO$_g$OS" is silicon-ungraded oxynitride II-nitride-ungraded oxynitride I-oxide-semiconductor.

"SO$_g$NOOS" is silicon-graded oxynitride II-nitride-ungraded oxynitride I-memory oxide-semiconductor.

"SO$_g$NO$_g$SO" is silicon-graded oxynitride II-nitride-graded oxynitride I-memory oxide-semiconductor.

The single oxynitride in SNOOS or SNO$_g$OS devices is referred to as oxynitride I or memory oxynitride. Finally, while discussing SONOOS, SO$_g$NOOS, SONO$_g$OS and SO$_g$NO$_g$OS devices, the oxynitride formed over the oxide is referred to as (graded or ungraded, as the case may be) oxynitride I or memory oxynitride (e.g., SONOOS) and the oxynitride formed over the nitride is referred to as (graded or ungraded, as the case may be) oxynitride II or interfacial oxynitride (e.g. SONOOS).

In brief summary, in one embodiment of this invention the memory device consists of a silicon-gate oxynitride II-nitride-oxynitride I-oxide-silicon substrate structure. The two oxynitride layers may have a graded (varying) or ungraded (uniform) composition of oxygen and nitrogen. In the SO$_g$NO$_g$OS structure, the composition of the oxynitride I layer is such that the oxygen:nitrogen ratio varies, in increments, from a maximum at the oxide-oxynitride I interface to a minimum at the oxynitride I-nitride interface and the composition of the oxynitride II layer is such that the oxygen:nitrogen ratio varies, the increments, from a minimum at the nitride-oxynitride II interface to a maximum at the oxynitride II-silicon interface. In the $SO_gNOOS$ structure, the interfacial oxynitride is graded in the same fashion as the corresponding oxynitride layer in the $SO_gNO_gOS$ structure. In the $SONO_gOS$ structure, the memory oxynitride is graded in the same fashion as the corresponding oxynitride in the $SO_gNO_gOS$ structure. In another embodiment of the present invention the memory device consists of an $SNO_gOS$ structure, where the single oxynitride I is graded in the same fashion as the oxynitride I in the $SO_gNO_gOS$ structure discussed above.

In brief summary of one embodiment of a process according to the invention, there is first formed a thin silicon oxide layer over a semiconductor substrate. Then the oxynitride and nitride layers are continuously formed over the thin oxide, all in the same deposition furnace tube, at the same temperature using the low pressure chemical vapor deposition (LPCVD) technique and by controlling the reactant gases used for forming these layers. In the $SNO_gOS$ structure, the single graded oxynitride I layer is formed by gradually varying the oxygen:nitrogen ratio from a maximum at the oxide-oxynitride I interface to a minimum at the oxynitride I-nitride interface. In the $SO_gNO_gOS$ structure the oxynitride I layer is formed as described in connection with the $SNO_gOS$ device and the oxynitride II layer is formed by varying the oxygen:nitrogen ratio gradually from a minimum at the nitride-oxynitride II interface to a maximum at the oxynitride II-silicon interface. In the $SO_gNOOS$ and $SONO_gOS$ structure the graded oxynitride II and graded oxynitride I, respectively, are formed in the same fashion as the corresponding graded oxynitride layers in the $SO_gNO_gOS$ structure. In the SONOOS structure, the two oxynitride layers are formed using a fixed oxygen:nitrogen ratio.

Brief description of the drawings

Fig. 1 is a cross-sectional representation of an embodiment of the non-volatile memory device according to the present invention.

Fig. 1A—1D show in a cross-sectional representation the various steps of forming the memory device of Fig. 1 in accordance with the process of this invention.

Fig. 2 is a cross-sectional view of a second embodiment of the non-volatile memory device according to the present invention.

Fig. 3 is a cross-sectional view of a non-volatile trigate memory device formed using this invention.

Fig. 4 is a schematic representation of an LPCVD system suitable for forming the gate structures in accordance with the process of this invention.

Fig. 5 is a graphical illustration comparing the retention of the devices of this invention and prior art devices.

Best mode for carrying out the invention

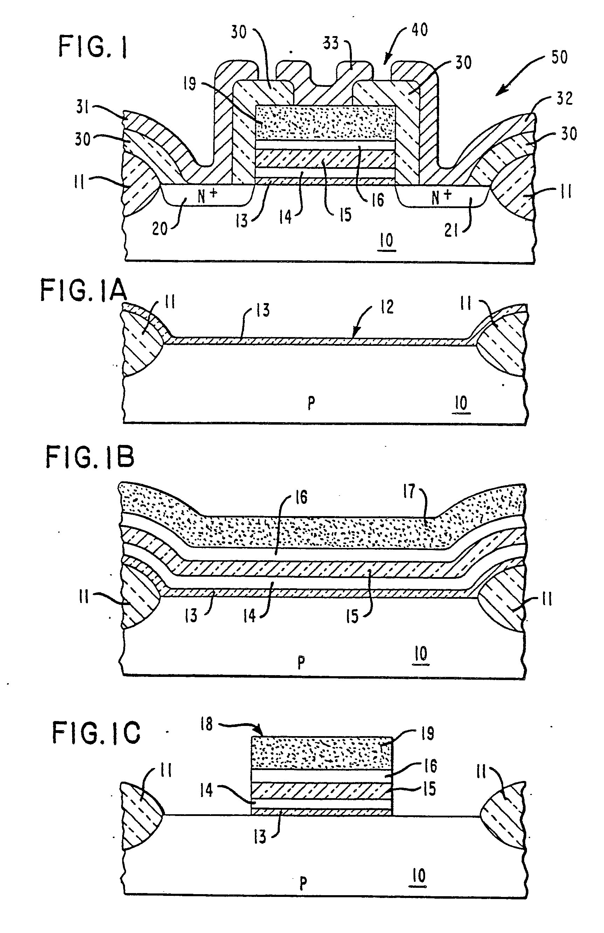

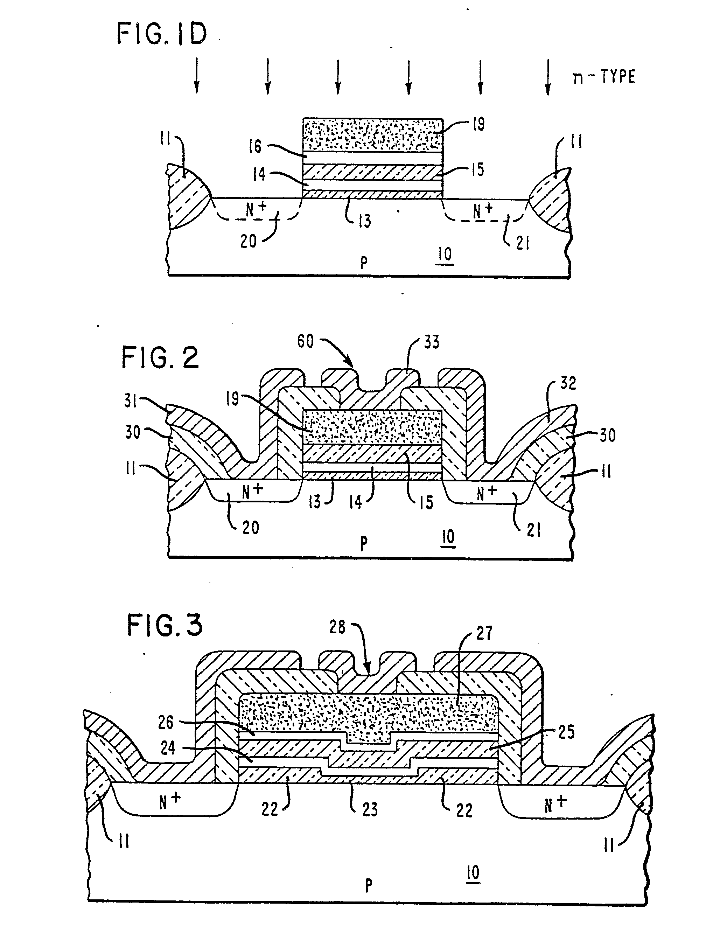

Referring now to Fig. 1 there is shown in this figure a partial sectional view of a portion of an exemplary memory device 50 embodying the principles of the present invention. Fig. 1, in particular, illustrates an n-channel transistor 50 having a silicon-oxynitride II-nitride-oxynitride I-oxide-silicon or SONOOS gate structure 40. The device 50 of Fig. 1 comprises a substrate 10 of one conductivity type, illustratively, p-type silicon. The n-channel transistor 50 includes a pair of n-type surface-adjacent source and drain impurity regions 20 and 21, respectively, which are implanted or diffused into the substrate, and a pair of isolation oxide regions 11—11. The gate structure 40 which overlies the channel region between the source and drain regions includes, in order, a thin layer of gate oxide 13, a first silicon oxynitride (hereafter oxynitride I or memory oxynitride) layer 14, a silicon nitride layer 15, a second silicon oxynitride (hereafter oxynitride II or interfacial oxynitride) layer 16 and a silicon gate electrode 19. Gate electrode 19 is doped with n-type impurities to provide a highly conductive gate electrode for the memory device.

In one embodiment both oxynitride layers 14 and 16 (Fig. 1) consist of a variable composition of oxygen and nitrogen resulting in graded oxynitride layers and obtaining an $SO_gNO_gOS$ structure. The grading in oxynitride I (14, Fig. 1) is such that the oxygen to nitrogen ratio in this layer varies from a maximum at the oxide (13)-oxynitride I (14) interface to a minimum at the oxynitride I(14)-nitride (15) interface. The grading in oxynitride II (16, Fig. 1) is such that the oxygen to nitrogen ratio in this layer varies from a minimum at the nitride (15)-oxynitride II (16) interface to a maximum at the oxynitride II (16)-silicon 19 interface. Other embodiments of this invention include the $SONO_gOS$ and $SO_gNOOS$ structures. The grading of the respective oxynitride layers in the just-mentioned structures is analogous to the grading in the corresponding oxynitride layers of the embodiment discussed above.

The memory device of Fig. 1 is provided with a thick insulating layer 30 made of, for example, phosphosilicate glass, which is appropriately patterned to cover the transistor structure. Insulating layer 30 electrically isolates the polysilicon gate 19 from the overlying metal conductors 31 and 32. Electrical conductors 31 and 32, made of, for example, aluminum, couple source 20 and drain 21, respectively, to associated electrical circuitry (not shown) such as a voltage supply. Electrical conductor 33 is connected to the gate.

Referring now to Fig. 2, there is shown another exemplary embodiment in accordance with the principles of this invention. This embodiment differs from the embodiment shown in Fig. 1 in that the gate structure 60 (Fig. 2) consists of a single oxynitride I layer instead of two oxynitride layers resulting in an $SNO_gOS$ structure. The grading in the single oxynitride layer of this device is analogous to that in the graded oxynitride I layer (14) of Fig. 1 discussed fully above.

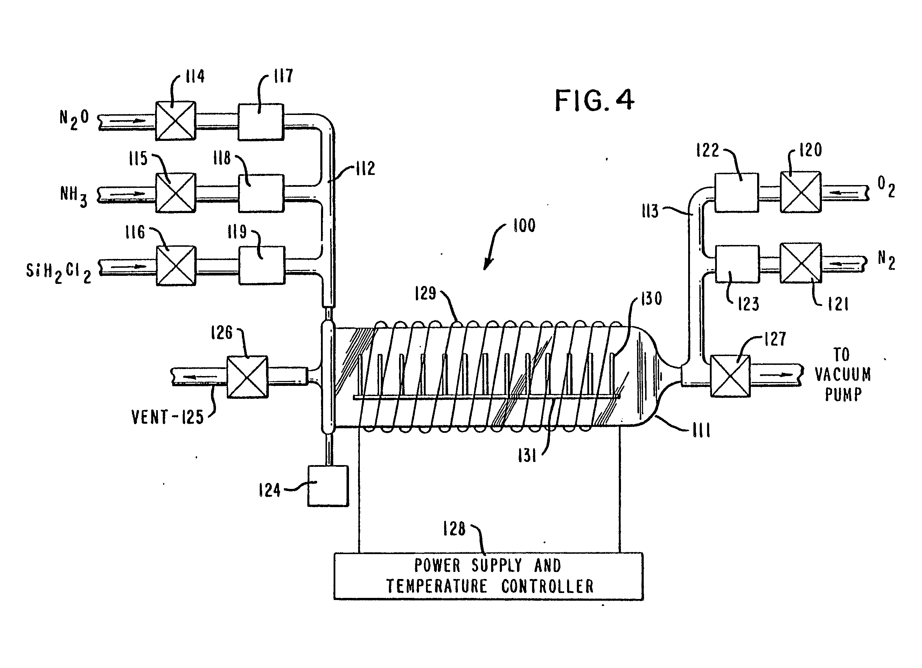

The LPCVD system used to form the oxide, oxynitride, nitride and silicon layers is shown in a schematic representation in Fig. 4. The System 100 consists of an LPCVD furnace including a furnace tube 111, typically made of fused quartz. Inert and reactant gases are admitted to the tube 111 via manifolds 112 and 113. That is, nitrous oxide ($N_2O$), ammonia ($NH_3$) and dichlorosilane ($SiH_2Cl_2$, also referred to herein as DCS) are admitted to manifold 112 via ON-OFF valves 114, 115 and 116, respectively, and their flow rates are controlled by conventional electronic mass flow controllers 117, 118 and 119. Similarly, oxygen ($O_2$) and nitrogen ($N_2$) are admitted to manifold 113 via ON-OFF valves 120 and 121 and their flow rates are controlled by mass flow controllers 122 and 123. A pressure sensor 124 is connected to the interior of the tube 111 for providing readings of the internal pressure.

In the exemplary arrangement shown in Fig. 4, vent 125 is opened and closed by ON-OFF valve 126 to allow the exit of oxygen and nitrogen from the tube 111 during the wafer loading and oxidation and unloading cycles.

The manifold 113 has an ON-OFF valve 127 for controlling the connection of the tube 111 to a vacuum pump (not shown). A power supply and temperature controller 128 connect to resistance heating coil 129 for heating the tube 111.

As shown in Fig. 4, the silicon wafers 130, from which the memory devices of this invention are fabricated, are supported in boat 131.

Reference is now made to Figs. 1A—1D wherein the successive steps of the fabrication process of the present invention are illustrated giving numerous specific details in order to provide a thorough understanding of the invention. The description that follows relates to a non-volatile memory device having a $SO_gNO_gOS$ structure. The following description also relates to the fabrication of n-channel devices but it should be understood that one having ordinary skill in the art can easily adapt the process to the fabrication of p-channel devices, or a combination of both, i.e., CMOS. It will be obvious to one skilled in the microelectronics art that the specific processes for implementing the various steps may be carried out in a number of different ways.

The drawings herein are not to scale. Dimensions have been expanded where needed in order to clearly show the structure.

Fig. 1A shows a portion of a p-type semiconductor substrate 10 having thick silicon oxide regions 11 formed therein adjacent to its surface. The thick oxide regions 11 are grown using a conventional localized oxidation of silicon (LOCOS) process at an elevated temperature (typically in the range of 900—1200°C.) for 10—20 hours. The thick oxide regions 11 electrically isolate adjacent devices and also define the device active regions. One such active region is shown in Fig. 1A where it is designated by the numeral 12. The thickness range of region 11 is typically 1—2 µm (10,000—20,000 Angstroms). After growing the thick oxide regions a thin, uniform, memory quality silicon dioxide layer 13 is formed in the active region 12 by thermal oxidation of the silicon substrate 10. An exemplary procedure for forming the oxide layer 13 is to introduce the semiconductor structure into the LPCVD system furnace tube 111 (Fig. 4), maintained at a temperature of about 700—900°C. and a pressure of about 1 atmosphere and having a gaseous oxygen flow therethrough, and oxidize the structure. The thickness of the thin oxide layer 13 is typically in the range of 0.0015—0.0030 µm (15—30 Angstroms).

Next, as shown in Fig. 1B, the first silicon oxynitride I layer 14, the silicon nitride layer 15 and the second silicon oxynitride II layer 16 are continuously formed by low pressure chemical vapor deposition without interruption in the same LPCVD system at the same temperature.

To form the oxynitride I layer 14, without changing the temperature of the furnace tube the reactant gases, ammonia, dichlorosilane and nitrous oxide are introduced into the system such that the proportion of ammonia:dichlorosilane:nitrous oxide is about 3.5:1:2 at the beginning of forming the oxynitride I layer and this proportion is gradually reduced in a step sequence to about 3.5:1:0 ($N_2O$ flow cut off) at the completion of forming the oxynitride I layer. In other words, the oxynitride I layer is formed such that the oxygen:nitrogen content is gradually decreased from a maximum at the memory oxide-oxynitride I interface to a minimum at the oxynitride I-silicon nitride interface, the latter to be formed in the immediately following step. During the oxynitride I deposition, the pressure inside the furnace tube is in the range of about 44—133 Pa (0.3—1 torr) and typically about 67 Pa (0.5 torr). The thickness of the oxynitride I layer 14 so formed is in the range of 20—80 Angstroms (0.002—0.008 microns).

Next, without changing the temperature the silicon nitride layer 15 is formed over the oxynitride I layer 14 by maintaining the mass flow of ammonia and dichlorosilane such that the ammonia:dichlorosilane ratio is about 3.5:1. During this deposition step, the internal tube pressure is maintained in the range of about 44—133 Pa (0.3—1 torr), preferably at the same pressure at which oxynitride I was deposited. The thickness of the nitride layer 15 formed in this manner is in the range of 0.02—0.04 µm (200—400 Angstroms).

After forming the nitride layer 15 of the desired thickness, without changing the temperature gaseous $N_2O$ is gradually reintroduced into the LPCVD system reaction chamber to form the oxynitride II layer 16. The reactant gas ratio is varied such that the proportion of ammonia:dichlorosilane:nitrous oxide is 3.5:1:0 at the beginning of forming the oxynitride II layer and this proportion is 3.5:1:2 at the completion of forming the oxynitride II layer. In other words, the oxygen:nitrogen ratio in the oxynitride II layer is a minimum at the nitride-oxynitride II interface and this ratio increases stepwise to a maximum at the oxynitride II-silicon interface, the latter to be formed in the next step. During this deposition step, the internal tube pressure is maintained at a fixed level in the range of about 44—133 Pa (0.3—1 torr), preferably at the same pressure at which the oxynitride I layer 14 and nitride 15 were deposited. The thickness of the oxynitride II layer 16 is typically in the range 0.006—0.02 µm (60—200 Angstroms).

The two oxynitride layers 14 and 16 formed in the manner described above thus have varying oxygen and nitrogen composition. In the first oxynitride layer 14, the oxygen:nitrogen ratio varies in increments from a maximum at the memory oxide 13-oxynitride I 14 interface to a minimum at the oxynitride I 14-nitride 15 interface. In the second oxynitride layer 16, the oxygen-nitrogen ratio varies from a minimum at the nitride 15-oxynitride II 16 interface to a maximum at the oxynitride II 16-silicon 17 interface.

After forming the oxynitride II layer 16, as shown in Fig. 1B, a layer 17, typically, of silicon, is formed over the entire structure by using conventional techniques such as LPCVD or atmospheric pressure CVD over the temperature range 600—700°C. using silane $(SiH_4)$ or dichlorosilane $(SiH_2Cl_2)$ ambients respectively to a thickness of about 0.3—0.5 µm (3,000—5,000 Angstroms).

Subsequent to the silicon deposition, using conventional photolithographic techniques, the silicon layer 17, the oxynitride II layer 16, the nitride layer 15, the oxynitride I layer 14 and the memory oxide layer 13 are etched to define the silicon gate structure 18 shown in Fig. 1C. In this figure, 19 designates the silicon gate electrode. The various dielectric layers 13—16 of the gate structure 18 are in precise alignment with the silicon gate 19.

Referring now to Fig. 1D, the n-type source 20 and the drain 21 are then formed, for example, by n-type ion implantation or by a standard high temperature (900°C.) diffusion of an n-type impurity such as phosphorus from an n-doped silicon dioxide glass layer (not shown) formed on the entire structure. In accomplishing this doping step, the gate structure 18 can be used as a mask which serves to align the transistor's source 20 and drain 21 with the gate electrode 19. A self-aligned silicon gate, as is well-known, improves performance of the device. Also in accomplishing this doping step, the silicon gate 19 can be doped $n^+$ thereby making it highly conductive, to reduce power dissipation and increase the speed of operation of the device. As shown in Fig. 1, the resulting structure is covered with an insulating layer 30, made of, for example, phospho-silicate glass for electrically isolating the gate structure from the next-to-be formed source and drain metal contacts 31 and 32.

As shown in Fig. 1, the structure is then coated with a contact metal such as aluminum which is then etched to create metal contacts 31, 32 and 33 in the conventional manner. In addition, protective or passivating layers over the device can be formed as desired. However, this type of layer is not shown and described herein inasmuch as it is a standard well-known technique.

The following Table I provides a summary of suitable parameters for forming a $SO_gNO_gOS$ structure in accordance with the teaching of this invention.

TABLE I
Process parameters

Memory silicon oxide (dry thermal silicon oxidation)
    Pressure                                       atmosphere

    Temperature                             700—850°C.

    Ambient                                  dry oxygen

Silicon oxynitride I (LPCVD)
    Pressure                              44—133 Pa (0.3—1.0 torr)

    Temperature                             700—950°C.

    Reactants ratio                        $NH_3:SiH_2Cl_2:N_2O$ varies from 3.5:1:2 at the beginning to 3.5:1:0 at the end.

Silicon nitride (LPCVD)
    Pressure                              44—133 Pa (0.3—1.0 torr)

    Temperature                             700—950°C.

    Reactants ratio                        (3—4):1 $NH_3:SiH_2Cl_2$

Silicon oxynitride II (LPCVD)
    Pressure                              44—133 Pa (0.3—1.0 torr)

    Temperature                             700—950°C.

    Reactants ratio                        $NH_3:SiH_2Cl_2:N_2O$ varies from 3.5:1:0 at the beginning to 3.5:1:2 at the end.

Example [$SO_gNO_gOS$]

In one example of forming a $SO_gNO_gOS$ structure according to the process of this invention, first, as discussed above, the memory oxide layer 13 (Fig. 1) of thickness of approximately 20 Angstroms was formed by dry thermal oxidation, in the presence of pure, dry oxygen flow of 4,000 cc. per minute on a silicon substrate 10 supported in the LPCVD system furnace tube 111 which was maintained at atmospheric pressure at a temperature of about 750°C. After forming the oxide layer 13, the oxygen flow was cut-off and any residual oxygen was pumped out of the furnace tube. Next, maintaining the furnace pressure at about 67 Pa (0.5 torr) using a reactant gas mixture of ammonia/dichlorosilane/nitrous oxide and without changing the temperature the graded oxynitride I 14, the nitride 15 and the graded oxynitride II 16 layers were continuously formed without interruption by programming the mass flow controls of the LPCVD system. The graded oxynitride I layer 14 was formed using a deposition sequence which was divided into four segments as explained below. First, ammonia at a flow rate of 70 sccm was caused to flow through the chamber for about 10 minutes to purge the LPCVD system. The ammonia flow rate was maintained at this rate throughout the oxynitride I deposition sequence. In the next step, $N_2O$, at a flow rate of 40 sccm was introduced into the reaction chamber for a period of about 2 minutes to ensure that the chamber pressure and temperature remain stable at 67 Pa (0.5 torr) and 750°C, respectively, prior to introduction of DCS. Then, the first segment of the graded oxynitride I deposition was initiated by introducing into the LPCVD chamber DCS at a flow rate of 20 sccm for about 1 minute. During this segment, the proportion of $NH_3:DCS:N_2O$ was 3.5:1:2, providing the maximum oxygen:nitrogen ratio. Next, the DCS flow was cut off and $N_2O$ flow was decreased to 30 sccm. After stabilizing the system by maintaining the $N_2O$ and $NH_3$ flow rates, the second segment of graded oxynitride I deposition was formed by introducing DCS at the same flow rate of 20 SCCM as before for about 1 minute. During this segment the $NH_3:DCS:N_2O$ proportion was 3.5:1:1.5. The third and fourth segments of the graded oxynitride I were accomplished in the same manner as the previous two segments, by using $N_2O$ flow rate of 20 sccm and 10 sccm, respectively. In other words, the proportion of $NH_3:DCS:N_2O$ for the third and fourth segments were, respectively, 3.5:1:1 and 3.5:1:0.5. The oxynitride I so formed was of a

6

thickness of approximately 0.004 μm (40 Angstroms).

After forming the graded oxynitride I layer 14, the LPCVD nitride layer 15 was formed by maintaining the flow rates of ammonia and dichlorosilane at 70 sccm and 20 sccm respectively (i.e. the ratio of $NH_3$:DCS was 3.5:1) but completely cutting off the $N_2O$ flow. The nitride formed in this manner was of thickness approximately 0.028 μm (280 Angstroms).

Next, the graded oxynitride II layer 16 was formed over the nitride 15 by reversing the four-segment deposition sequence used for forming the graded oxynitride I layer 14. In other words, after purging the system with ammonia, introducing $N_2O$ at a flow rate of 10 sccm and stabilizing the chamber for about 1 minute, DCS was introduced at a flow rate of 20 sccm for about 1 minute. This was the first segment of the four-segment deposition sequence. In the second, third and fourth segments of the oxynitride II deposition sequence (the DCS and ammonia flow rates were maintained at 20 sccm and 70 sccm respectively) the $N_2O$ flow rates used were 20 sccm, 30 sccm and 40 sccm respectively. The oxynitride II layer 16 so formed was of approximately 0.008 μm (80 Angstroms) thickness.

Example [SONO$_g$OS]

To form a silicon gate-ungraded oxynitride II-nitride-graded oxynitride I-oxide-silicon substrate or SONO$_g$OS structure, the sequence of steps discussed above in connection with forming the SO$_g$NO$_g$OS structure is used with the modification that during the oxynitride II deposition, the ammonia:dichlorosilane: nitrous oxide proportion is not varied but fixed at a preselected value in the range 3.5:1:0.5 to 3.5:1:2.

Example [SO$_g$NOOS]

To form a silicon gate-graded oxynitride II-nitride-ungraded oxynitride I-oxide-silicon substrate or SO$_g$NOOS structure, the process steps discussed in connection with forming the SO$_g$NO$_g$OS structure is used with the modification that during the oxynitride I deposition, the ammonia:dichlorosilane:nitrous oxide proportion is not varied but fixed at a preselected value in the range 3.5:1:0.5 to 3.5:1:2.

Example [SNO$_g$OS]

To form the embodiment of this invention (shown in Fig. 2) having a silicon 19-nitride 15-graded oxynitride 14-oxide 13-silicon substrate 10 or SNO$_g$OS structure, the process of this invention discussed above in connection with the SO$_g$NO$_g$OS structure is used with the significant modification that the sequence of steps used to form the graded oxynitride II layer 16 (Fig. 1) are omitted. In other words, after forming the nitride layer over graded oxynitride I layer 14, silicon 19 is deposited over the entire structure.

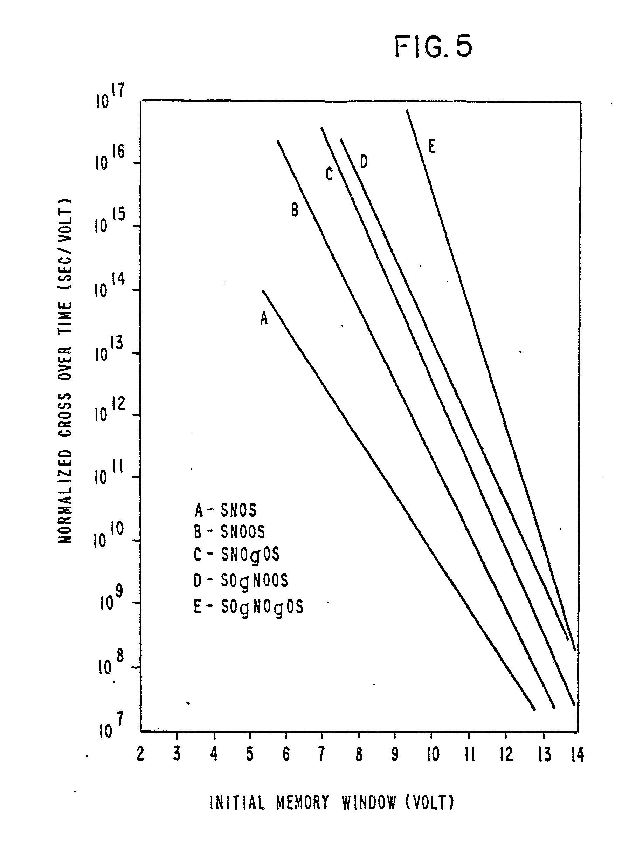

To illustrate the improved retention characteristcs of the novel devices of the present invention, several n-channel devices were fabricated, tested and the test results evaluated. These devices include an SNOS device formed in the conventional manner, an SNOOS device having an oxynitride layer of a thickness in the range of 0.005—0.02 μm (50—200 Angstroms) and a nitride layer of a thickness in the range of 0.03—0.065 μm (300—650 Angstroms), an SNO$_g$OS device (having the basic structure shown in Fig. 2) and SO$_g$NO$_g$OS and SO$_g$NOOS devices (having the basic structure shown in Fig. 1), the latter three devices formed in accordance with the teachings of this invention. The test results which focus on the rentention characteristics of these devices are summarized in Fig. 5.

The procedure used for testing the devices fabricated in the manner described above is well-known. The write and erase curves were generated, for example, by subjecting the devices to various pulse stressing conditions (pulse amplitudes and duration). The amplitude of the pulse was ±25 volts, the positive and negative values being applicable to the write and erase data, respectively.

The data to determine the charge retention in the devices was obtained by: (1) initializing the devices and determining the initial write and erase threshold voltages; and (2) obtaining rentention graphs of the devices by storing the devices at an elevated temperature of 100°C for a time of up to $10^5$ seconds and determining the threshold voltages at intervals during this time. The initialization procedure (step 1) i.e. obtaining the initial written and erased state threshold voltages, involved applying a +25 volt pulse of ten millisecond duration and a −25 volt pulse of 100 millisecond duration, respectively, to the gates of the memory devices. Source 20, drain 21 and substrate 10 (Figs. 1 and 2) were all tied to the ground during this initialization. Using the rentention data obtained in the above fashion, the graph of Fig. 5 was constructed.

Fig. 5 is a plot of the normalized crossover time versus initial memory window for various devices. Normalized crossover time designates the time of crossover of the write and erase retention curves divided by the initial memory window. This parameter is a measure of the device retention and, generally, the larger the normalized crossover time the better is the retention. In most applications, it is desirable to have a memory device having a larger initial window and a long normalized crossover time.

In Fig. 5 the lines labeled A, B, C, D and E represent (A) the retention data for the conventional SNOS device, (B) the SNOOS device, (C) the SNO$_g$OS, (D) SO$_g$NOOS and (E) SO$_g$NO$_g$OS devices in accordance with the teachings of this invention, respectively. In all of these devices, the memory oxide thickness was in the range of 0.002—0.003 μm (20—30 Angstroms). Also, the oxynitride I and oxynitride II layers in the devices of this invention were of a thickness in the ranges 0.002—0.006 μm (20—60 Angstroms) and 0.007—0.009 μm (70—90 Angstroms), respectively.

Furthermore, the combined thickness of all the gate dielectric layers in all the tested devices was in the range 0.036—0.047 μm (360—470 Angstroms). The total dielectric thickness was maintained in this range by varying the nitride layer thickness to accommodate the presence or absence of the oxynitride I and oxynitride II layers. The various thickness measurements were obtained using the deposition rate and time of forming the layers. The various dielectric layers common to each of the tested devices, including those of the conventional SNOS and SNOOS devices, were formed using the same temperature, pressure and deposition kinetics.

The results of Fig. 5 demonstrate, among other benefits of the present invention, that: (1) the $SNO_gOS$ memory device of this invention has an improved retention over both the conventional SNOS and SNOOS devices. In other words, a memory device having a graded oxynitride-nitride dual gate dielectric has an improved retention over the conventional devices having, respectively, a single nitride gate dielectric and a dual ungraded oxynitride-nitride gate dielectric. (2) The $SO_gNOOS$ memory device of the present invention shows improved retention over not only the conventional SNOS and SNOOS devices, but also the $SNO_gOS$ device of this invention discussed in item (1) immediately above. In other words an interfacial graded oxynitride improves the retention still further. (3) The $SO_gNO_gOS$ memory device of this invention shows a marked improvement in retention over not only the conventional SNOS and SNOOS devices but also the new $SNO_gOS$ and $SO_gNOOS$ devices discussed in items (1) and (2) above.

Measurements were also taken to determine the endurance characteristic of the above novel devices, by subjecting them to program and erase cycling of up to $10^5$ times using pulses of amplitude ±25 volts and width 10 milliseconds and 100 milliseconds respectively. It was found that although the repetitive programming and erasing somewhat degraded the devices' memories, there was adequate charge retention after such cycling. This demonstrates that the devices are fit for practical use even when they are subjected to normal repetitive program and erase cycles.

It is not clear just how the above multidielectric structures of the present invention contribute to the improved retention of the memory devices. One possible explanation is that the novel structures and the unique process parameters selected to form the structures contribute to the improved retention by enhancing the current density in the multidielectric layer. Another possible explanation is that the oxynitride layer(s) act as a barrier for charge leakage after the device is written or erased. The above explanations should, however, be regarded merely as plausibility arguments rather than as proven fact.

Thus, there has been described novel memory devices having novel, graded multilayer gate dielectric structures and processes for forming these structures. These include: (1) $SO_gNO_gOS$; (2) $SONO_gOS$; (3) $SO_gNOOS$; and (4) $SNO_gOS$ device. Each of these devices has a a novel gate dielectric structure and improved retention over the conventional non-volatile silicon memory gate devices.

Although the description of the present invention so far has been confined to a monogate structure, this process is equally well-suited to split gate and trigate memory structures taught in U.S Patent No. 3,719,866, issued March 6, 1973, to Naber and Lockwood and assigned to the assignee of the present invention. Referring to Fig. 3., after forming the thick isolation oxide regions 11 a relatively thick silicon dioxide layer 22, of thickness about 0.05 μm (500 Angstroms) is formed over the substrate 10. Then, a central portion of this oxide layer is etched down to the substrate using conventional photolithographic techniques. Thereafter, a memory oxide 23 (Fig. 3), typically 0.002 μm (20 Angstroms) thick, is formed in this etched portion. The remainder of the steps of forming the SONOOS trigate structure follows the sequence explained in connection with forming the monogate structure. The trigate structure 28 (Fig. 3) formed according to the process of this invention would thus consist of two relatively thick gate oxide portions 22—22 and a thin memory oxide portion 23. Overlying these oxide portions are the oxynitride I layer 24, the nitride layer 25, the oxynitride II layer 26 and the polysilicon gate 27.

There are many uses to which the invented device may be applied. These applications include non-volatile electrically alterable memory for very large scale integrations, high speed and low voltage EAROMs and shift registers for bulk storage.

## Claims

1. A non-volatile semiconductor memory device including a semiconductor substrate (10), a silicon oxide layer (13) provided on said semiconductor substrate (10), a silicon oxynitride layer (14) provided on said silicon oxide layer (13), a silicon nitride layer (15) provided on said oxynitride layer (14), and a silicon gate electrode (19) overlying said silicon nitride layer (15), characterized in that said silicon nitride layer (15) is in contact with a layer of graded silicon oxynitride (14, 16) which may be constituted by said silicon oxynitride layer (14) provided on said silicon oxide layer (13), and has an oxygen:nitrogen ratio varying in steps from a minimum at the boundary thereof in contact with said silicon nitride layer to a maximum at the remote boundary thereof.

2. A non-volatile semiconductor memory device according to claim 1, characterized in that said layer of graded silicon oxynitride is provided as a further layer (16) of silicon oxynitride lying between said silicon nitride layer (15) and said silicon gate electrode (19).

3. A non-volatile semiconductor memory device according to claim 2, characterized in that both silicon oxynitride layers (14, 16) are formed by layers of graded silicon oxynitride.

4. A non-volatile semiconductor memory device according to claim 2, characterized in that said further layer (16) has a thickness in the range 0.006—0.02 µm (60—200 Angstroms).

5. A non-volatile semiconductor memory device according to claim 1, characterized in that said silicon oxynitride (14) provided on said silicon oxide layer (13) has a thickness in the range of 0.002—0.008 µm (20—80 Angstroms).

6. A non-volatile semiconductor memory device according to any one of the preceding claims, characterized in that the combined thickness of all the silicon bearing materials formed between said substrate (10) and said gate electrode (19) is in the range 0.036—0.47 µm (360—470 Angstroms).

7. A process for forming a non-volatile semiconductor memory device including the steps of providing a semiconductor substrate (10), providing a silicon oxide layer (13) on said semiconductor substrate (10), providing a silicon oxynitride layer (14) on said silicon oxide layer (13), providing a silicon nitride layer (15) on said oxynitride layer (14) and providing a silicon gate electrode (19) overlying said silicon nitride layer (15), characterized by the step of providing, in contact with said silicon nitride layer (15), a layer of graded silicon oxynitride (14, 16) which may be constituted by said silicon oxynitride layer (14) provided on said silicon oxide layer (13), and which has an oxygen:nitrogen ratio varying in steps from a minimum at the boundary thereof in contact with said silicon nitride layer to a maximum at the remote boundary thereof.

8. A process according to claim 7, characterized by the step of providing a further layer (16) of silicon oxynitride constituting said layer of graded silicon oxynitride lying between said silicon nitride layer (15) and said silicon gate electrode (19).

9. A process according to claim 8, characterized by the step of providing said silicon oxynitride layer (14) in the form of a layer of graded silicon oxynitride.

10. A process according to claim 7, characterized in that said step of providing a layer of graded silicon oxynitride (14) is effected by utilizing the reactant gases ammonia, dichlorosilane and nitrous oxide in an ammonia:dichlorosilane:nitrous oxide proportion varying from about 3.5:1:2 at the beginning to about 3.5:1:0 at the end.

11. A process according to claim 8, characterized in that said step of providing a further layer (16) of silicon oxynitride constituting said layer of graded silicon oxynitride is effected by utilizing the reactant gases ammonia, dichlorosilane and nitrous oxide in an ammonia:dichlorosilane:nitrous oxide proportion varying from about 3.5:1:0 at the beginning to about 3.5:1:2 at the end.

12. A process according to claim 10 or 11, characterized in that said reactant gases are utilized for low pressure chemical vapor deposition at a pressure in the range of about 44—133 Pa (0.3—1.0 torr.) and at a temperature in the range 700—950°C.

13. A process according to claim 10 or 11, characterized in that the ammonia:dichlorosilane:nitrous oxide proportion is varied in steps.

14. A process according to claim 10 or 11, characterized in that said step of forming said silicon nitride layer (15) is effected utilizing the reactant gases ammonia and dishlorosilane.

**Patentansprüche**

1. Nichtflüchtige Halbleiterspeichervorrichtung mit einem Halbleitersubstrat (10), einer Siliziumoxidschicht (13), die auf dem Halbleitersubstrat (10) vorgesehen ist, einer Siliziumoxynitridschicht (14), die auf der Siliziumoxidschicht (13) aufgebracht ist, einer Siliziumnitridschicht (15), die auf der Oxynitridschicht (14) aufgebracht ist, und einer Siliziumgateelektrode (19), die über der Siliziumnitridschicht (15) liegt, dadurch gekennzeichnet, daß die Siliziumnitridschicht (15) in Kontakt ist mit einer Schicht eines graduierten Siliziumoxynitrid (14, 16), das bestehen kann aus der Siliziumoxynitridschicht (14) auf der Siliziumoxidschicht (13), und ein Sauerstoff-zu-Stickstoff-Verhältnis besitzt, das in Stufen sich von einem Minimum an deren Grenze in Kontakt mit der Siliziumnitridschicht zu einem Maximum an deren davon entfernten Grenze ändert.

2. Nichtflüchtige Halbleiterspeichervorrichtung nach Anspruch 1, dadurch gekennzeichnet, daß die Schicht von graduiertem Siliziumoxynitrid als eine weitere Schicht (16) von Siliziumoxynitrid aufgebracht ist, die zwischen der Siliziumnitridschicht (15) und der Siliziumgateelektrode (19) angeordnet ist.

3. Nichtflüchtige Halbleiterspeichervorrichtung nach Anspruch 2, dadurch gekennzeichnet, daß beide Siliziumoxynitridschicht (14, 16) durch Schichten von graduiertem Siliziumoxynitrid gebildet sind.

4. Nichtflüchtige Halbleiterspeichervorrichtung, nach Anspruch 2, dadurch gekennzeichnet, daß die weitere Schicht (16) eine Dicke im Bereich 0,006—0,02 µm (60—200 Angström) besitzt.

5. Nichtflüchtige Halbleiterspeichervorrichtung nach Anspruch 1, dadurch gekennzeichnet, daß das auf der Siliziumoxidschicht (13) afugebrachte Siliziumoxynitrid (14) eine Dicke in dem Bereich von 0,002—0,008 µm (20—80 Ångström) besitzt.

6. Nichtflüchtige Halbleiterspeichervorrichtung nach einem der vorhergehenden Ansprüche, dadurch gekennzeichnet, daß die kombinierte Dicke aller Silizium beinhaltenden Materialien zwischen dem Substat (10) und der Gateelektrode (19) im Bereich von 0,036—0,047 µm (360—470 Ångström) liegt.

7. Verfahren zum Bilden einer nichtflüchtigen Halbleiterspeichervorrichtung mit den Schritten Vorsehen eines Halbleitersubstrats (10), Aufbringen einer Siliziumoxidschicht (13) auf dem Halbleitersubstrat (10), Aufbringen einer Siliziumozynitridschicht (14) auf der Siliziumoxidschicht (13), Aufbringen einer Siliziumnitridschicht (15) auf der Oxynitridschicht (14) und Vorsehen einer Siliziumgateelektrode (19), die über der Siliziumnitridschicht (15) liegt, gekennzeichnet durch den Schritt Vorsehen einer Schicht von graduiertem Siliziumoxynitrid (14, 16) in Kontakt mit der Siliziumnitridschicht (15), welch erstere aus der Siliziumoxynitridschicht (14) bestehen kann, die auf der Siliziumoxidschicht (13) aufgebracht ist und die ein Sauerstoff-zu-Stickstoff-Verhältnis besitzt, das in Stufen sich von einem Minimum an deren Grenze in Kontakt mit der Siliziumnitridschicht zu einem Maximum an deren davon entfernten Grenze ändert.

8. Verfahren nach Anspruch 7, gekennzeichnet durch den Schritt Aufbringen einer weiteren Schicht (16) von Siliziumoxynitrid, die die Schicht des graduierten Siliziumoxynitrids darstellt, die zwischen der Siliziumnitridschicht (15) und er Siliziumgateelektrode (19) liegt.

9. Verfahren nach Anspruch 8, gekennzeichnet durch den Schritt Vorsehen einer Siliziumoxynitridschicht (14) in der Form einer Schicht von graduiertem Siliziumoxynitrid.

10. Verfahren nach Anspruch 7, dadurch gekennzeichnet, daß der Schritt Aufbringen einer Schicht von graduiertem Siliziumoxynitrid (14) ausgeführt wird durch Verwenden der Reagenzgase Ammoniak, Dichlorsilan und Distickstoffmonoxyd in einem Verhältnis Ammoniak:Dichlorsilan:Distickstoffmonoxyd, das sich von 3,5:1:2 zu Beginn bis etwa 3,5:1:0 am Ende ändert.

11. Verfahren nach Anspruch 8, dadurch gekennzeichnet, daß der Schritt des Aufbringens einer weiteren Schicht (16) von Siliziumoxynitrid, die die Schicht von graduiertem Siliziumoxynitrid darstellt, bewirkt wird durch Verwenden der Reagenzgase Ammoniak, Dichlorsilan und Distickstoffmonoxyd in einem Verhältnis Ammoniak:Dichlorsilan:Distickstoffmonoxyd, das sich von etwa 3,5:1:0 am Beginn bis etwa 3,5:1:2 am Ende ândert.

12. Verfahren nach Anspruch 10 oder 11, dadurch gekennzeichnet, daß die Reagenzgase verwendet werden zur chemischen Niederdruckdampfablagerung bei einem Druck im Bereich 44—133 Pa (0,3—1,0 torr) und bei einer Temperatur im Bereich von 700—950°C.

13. Verfahren nach Anspruch 10 oder 11, dadurch gekennzeichnet, daß Verhältnis Ammoniak:Dichlorsilan:Distickstoffmonoxyd in Stufen verändert wird.

14. Verfahen nach Anspruch 10 oder 11, dadurch gekennzeichnet, daß der Schritt Bilden der Siliziumnitridschicht (15) bewirkt wird durch Verwenden der Reagenzgase Ammoniak und Dichlorsilan.

## Revendications

1. Dispositif de mémoire rémanente à semiconducteurs comprenant un substrat semiconducteur (10), une couche (13) d'oxyde de silicium appliquée sur ledit substrat semiconducteur (10), une couche (14) d'oxynitrure de silicium appliquée sur ladite couche (13) d'oxyde de silicium, une couche (15) de nitrure de silicium appliquée sur ladite couche (14) d'oxynitrure, et une électrode (19) de grille en silicium s'étendant au-dessus de ladite couche (15) de nitrure de silicium, caractérisé en ce que ladite couche (15) de nitrure de silicium est en contact avec une couche d'oxynitrure de silicium dégradée (14, 16) qui peut être constituée par ladite couche (14) d'oxynitrure de silicium appliquée sur ladite couche (13) d'oxyde de silicium, et présente un rapport oxygéne:azote variant par pas d'un minimum à sa limite en contact avec ladite couche de nitrure de silicium jusqu'à un maximum à sa limite éloignée.

2. Dispositif de mémoire rémanente à semiconducteurs selon la revendication 1, caractérisé en ce que ladite couche d'oxynitrure de silicium dégradée est appliquée sous la forme d'une autre couche (16) d'oxynitrure de silicium s'étendant entre ladite couche (15) de nitrure de silicium et ladite électrode (19) de grille en silicium.

3. Dispositif de mémoire rémanente à semiducteurs selon la revendication 2, caractérisé en ce que les deux couches (14, 16) d'oxynitrure de silicium sont formées par des couches d'oxynitrure de silicium dégradée.

4. Dispositif de mémoire rémanente à semiconducteurs selon la revendication 2, caractérisé en ce que ladite autre couche (16) présente une épaisseur dans la plage de 0,006—0,02 µm (60—200 Angströms).

5. Dispositif de mémoire rémanente à semiconducteurs selon la revendication 1, caractérisé en ce que ledit oxynitrure de silicium (14) appliqué sur ladite couche (13) d'oxyde de silicium présente une épaisseur dans la plage de 0,002—0,008 µm (20—80 Angströms).

6. Dispositif de mémoire rémanente à semiconducteurs selon l'une quelconque des revendications précédentes, caractérisé en ce que l'épaisseur combinée de toutes les matières contenant du silicium, formées entre ledit substrat (10) et ladite électrode de grille (19), est dans la plage de 0,036—0,047 µm (360—470 Angströms).

7. Procédé pour former un dispositif de mémoire rémanente à semiconducteurs, comprenant les étapes qui consistent à utiliser un substrat semiconducteur (10), à appliquer une couche (13) d'oxyde de silicium sur ledit substrat semiconducteur (10), à appliquer une couche (14) d'oxynitrure de silicium sur ladite couche (13) d'oxyde de silicium, à appliquer une couche (15) de nitrure de silicium sur ladite couche (14) d'oxynitrure et à appliquer une électrode (19) de grille en silicium s'étendant au-dessus de ladite couche (15) de nitrure de silicium, caractérisé par l'étape que consiste à appliquer, en contact avec ladite couche (15) de nitrure de silicium, une couche d'oxynitrure de silicium dégradée (14, 16) qui peut être constituée par ladite couche (14) d'oxynitrure de silicium appliquée sur ladite couche (13) d'oxyde de silicium, et qui présente un rapport oxygène:azote variant par pas d'un minimum à sa limite en contact avec ladite couche de nitrure de silicium jusqu'à un maximum à sa limite éloignée.

8. Procédé selon la revendication 7, caractérisé par l'étape consistant à appliquer une autre couche (16) d'oxynitrure de silicium constituant ladite couche d'oxynitrure de silicium dégradées s'étendant entre ladite couche (15) de nitrure de silicium et ladite électrode de grille (19) en silicium.

9. Procédé selon la revendication 8, caractérisé par l'étape qui consiste à appliquer ladite couche (14) d'oxynitrure de silicium sous la forme d'une couche d'oxynitrure de silicium dégradée.

10. Procédé selon la revendication 7, caractérisé en ce que ladite étape d'application d'une couche d'oxynitrure de silicium dégradée (14) est effectuée par l'utilisation des gaz réactionnels que sont l'ammoniac, le dichlorosilane et l'oxyde nitreux, dans des proportions ammoniac:dichlorosilane:oxyde nitreux variant d'environ 3,5:1:2 au commencement à environ 3,5:1:0 à la fin.

11. Procédé selon la revendication 8, caractérisé en ce que ladite étape d'application d'une autre couche (16) d'oxynitrure de silicium constituant ladite couche d'oxynitrure de silicium dégradée est effectuée par l'utilisation des gaz réactionnels que sont l'ammoniac, le dichlorosilane et l'oxyde nitreux, dans des proportions ammoniac:dichlorosilane:oxyde nitreux variant d'environ 3,5:1:0 au commencement jusqu'à environ 3,5:1:2 à la fin.

12. Procédé selon la revendication 10 ou 11, caractérisé en ce que lesdits gaz réactionnels sont utilisés pour un dépôt de vapeur chimique à basse pression, sous une pression dans la plage d'environ 44—133 Pa (0,3—1,0 Torr) et à une température dans la plage de 700—950°C.

13. Procédé selon la revendication 10 ou 11, caractérisé en ce que les proportions ammoniac:dichlorosilane:oxyde nitreux sont modifiées par pas.

14 Procédé selon la revendication 10 ou 11, caractérisé en ce que ladite étape de formation de ladite couche (15) de nitrure de silicium est effectuée par l'utilisation des gaz réactionnels que sont l'ammoniac et le dichlorosilane.

FIG. I

30    33    40    50
19                30
31                32
30                30
11                11
N+                N+
20    13  14  15  16    21
10

FIG. IA

11    13    12    11
P    10

FIG. IB

16    17
11    11
13  14    15
P    10

FIG. IC

18    19
11    16
14    15
13
11    11
P    10

FIG. ID

n - TYPE

FIG. 2

FIG. 3

FIG. 4

# FIG. 5

A – SNOS
B – SNOOS
C – SNOgOS
D – SOgNOOS
E – SOgNOgOS

INITIAL MEMORY WINDOW (VOLT)

NORMALIZED CROSS OVER TIME (SEC/VOLT)